Europäisches Patentamt

(19) European Patent Office

Office européen des brevets

(11) Publication number: **0 235 785 B1**

# (12) EUROPEAN PATENT SPECIFICATION

(45) Date of publication of patent specification :
23.10.91 Bulletin 91/43

(51) Int. Cl.⁵ : **H01L 31/02, H01L 21/285**

(21) Application number : **87102929.4**

(22) Date of filing : **02.03.87**

(54) Semiconductor device.

(30) Priority : **03.03.86 JP 47122/86**

(43) Date of publication of application :
**09.09.87 Bulletin 87/37**

(45) Publication of the grant of the patent :
**23.10.91 Bulletin 91/43**

(84) Designated Contracting States :
**BE DE FR GB IT NL**

(56) References cited :
**EP-A- 0 069 992**
**US-A- 4 375 007**
**US-A- 4 510 344**
**PATENT ABSTRACTS OF JAPAN, vol. 9, no. 225 (E-342)[1948], 11th September 1985; & JP-A-60 83 382**
**PATENT ABSTRACTS OF JAPAN, vol. 7, no. 276 (E-215)[1421], 9th December 1983; & JP-A-58 157 176**
**PATENT ABSTRACTS OF JAPAN, vol. 9, no. 302 (E-362)[2025], 29th November 1985; & JP-A-60 140 881**
**PATENT ABSTRACTS OF JAPAN, vol. 9, no. 315 (E-365)[2038], 11th December 1985; & JP-A-60 147 171**

(73) Proprietor : **KANEGAFUCHI KAGAKU KOGYO KABUSHIKI KAISHA**
**2-4 Nakanoshima 3-chome**
**Kita-ku Osaka-shi Osaka-fu (JP)**

(72) Inventor : **Kobayashi, Kenji**
**Sanseiso, 6-31-17 Shioya-cho Kita-ku**
**Kobe-shi Hyogo-ken (JP)**
Inventor : **Kondo, Masataka**
**8-15, Kitagoyo 2-chome Kita-ku**
**Kobe-shi Hyogo-ken (JP)**
Inventor : **Tsuge, Kazunori**
**1220, 2-9-30, Maikodai Tarumi-ku**
**Kobe-shi Hyogo-ken (JP)**
Inventor : **Tawada, Yoshihisa**
**14-39, Oikemiyamadai Kita-ku**
**Kobe-shi Hyogo-ken (JP)**

(74) Representative : **Vossius & Partner**
**Siebertstrasse 4 P.O. Box 86 07 67**
**W-8000 München 86 (DE)**

**Description**

The present invention relates to a semiconductor device, and more particularly to a semiconductor device wherein a material for a metal electrode which can improve heat-resistance is used.

Conventional semiconductor devices such as amorphous silicon solar cells and pin type photosensors are produced by (1) forming a transparent conductive thin film comprising ITO, $ITO/SnO_2$, $SnO_2$, $IN_2O_3$, $Cd_xSnO_y$ (wherein x and y satisfy the relationships of $0.5 \leqq x \leqq 2$ and $2 \leqq y \leqq 4$, respectively), $Ir_zO_{1-z}$ (wherein z satisfies the relationship of $0.33 \leqq z \leqq 0.5$), and the like on a translucent substrate such as a glass or plastic film by means of the sputtering method, the electron beam vacuum deposition method, the thermal CVD method, the spray method, and the like, (2) forming an amorphous silicon layer having a pin structure on the transparent conductive thin film, and then (3) providing a metal electrode comprising, for example, Al, Ag, Ni, and the like by means of the resistance heating vacuum deposition method, the electron beam vacuum deposition method, and the like using a mask.

The conditions required for the above-mentioned metal electrode are as follows:

(1) Low electric resistance in spite of being a thin film.

(2) It should not form a potential barrier between a metal electrode and a semiconductor layer, and therefore have good ohmic resistance properties.

(3) High adhesive strength to a semiconductor layer.

(4) High reflectivity when a semiconductor device is a solar cell or a photosensor.

(5) Thermal stability and prevention of diffusion into the semiconductor layer.

These conditions have a significant influence on the characteristics and lifetime of semiconductor devices.

The materials generally used for conventional metal electrodes are Al, Ag, Ni, and the like. Among these materials, Al has superior properties as a single metal material with respect to the above items (1) to (4). However, Al has the drawback that it is apt to diffuse into the semiconductor at a high temperature if an amorphous silicon is employed as a semiconductor. Accordingly, if an Al electrode is exposed to a relatively high temperature when an amorphous semiconductor which might contain microcrystals and has an Al electrode is produced, or if the temperature rises during the use of a semiconductor device, Al is easily diffused into the semiconductor and lowers the properties of the semiconductors. Therefore, the manufacturing process of semiconductor devices is extremely limited and/or the lifetime of semiconductors extremely shortened. For example, if Al is employed as a backside electrode of an amorphous silicon solar cell intended for outdoor use, the temperature of the backside electrode rises up to about 80°C when it is irradiated by sunlight, whereby the performances of the solar cell are degraded.

Document EP-A-0 069 992 is concerned with contacts for photovoltaic cells in which zinc or another solderable soft metal is used in conjunction with aluminium in order to avoid the problem of bending of the solar cells when the contacts are applied by spraying methods.

The present invention was made to prevent the degradation of properties of semiconductor devices due to the diffusion of Al into the semiconductor. Said diffusion is generated (1) when the Al electrode is exposed to a relatively high temperature during the manufacturing process after the Al electrode has been formed, when an amorphous semiconductor which might contain microcrystals and which has an Al electrode is being produced, or (2) when the temperature rises during the use of a semiconductor device.

In accordance with the present invention, a semiconductor device is provided comprising an amorphous semiconductor which might contain microcrystals and a metal electrode electrically connected to the amorphous semiconductor and containing Al as a first component, characterized in that at least one element selected from the group consisting of (i) Ag, (ii) Au, (iii) Ca, Mg, Mn, W, Cr or Cu, (iv) Zn or Ge, and (v) Fe, Mo, Ni, Pd, Pt, Ti, V or Zr is added to the first component as an additional component of the metal electrode.

For the amorphous semiconductor which might contain microcrystals used in the present invention, any semiconductor is suitable as long as it is a amorphous silicon semiconductor or a amorphous silicon semiconductor which contains microcrystals. Concrete examples of such semiconductors include, for instance, a-Si:H, a-Si:F:H, a-Si:N:F:H, a-SiC:H, a-SiC:F:H, a-SiO:H, a-SiO:F:H, a-SiN:H, μc-Si:H, μc-Si:F:H and the like. These semiconductors can be of the p-type, n-type, or intrinsic semiconductors.

As a material for a metal electrode employed in the present invention which is electrically connected to the amorphous semiconductor which might contain microcrystals, it is preferable to use an Al alloy containing Al as a first component and, in the case of a binary alloy, an additional component having in particular such properties (as described hereinafter) which improve the heat-resistance of the obtained metal electrode.

(i) The formation of a primary solid solution with Al in a certain component range, which varies depending on the kind of element, when Al is rich, or of a homogeneous solid solution with Al in any component range, and of an eutectic crystal with Si over the entire range of constitution.

(ii) The absence of the formation of a primary solid solution with Al, but the formation of an eutectic crystal with Si over the entire range of constitution.

(iii) The formation of a primary solid solution with Al in a certain component range, which varies depending on the kind of element, when $A\ell$ is rich, or of homogeneous solid solution with $A\ell$ in any component range and of a silicide in a solid phase.

(iv) The formation of a primary solid solution with Al in a certain component range, which varies depending on the kind of element, when $A\ell$ is rich, or of a homogeneous solid solution with $A\ell$ in any component range, but the absence of the formation of a silicide.

(v) The absence of the formation of a primary solid solution with Al, but the formation of a silicide.

It is preferable to use one or more kinds of elements having the above properties as additional components.

Concrete examples of elements which satisfy the above items (i) to (v) include, for instance, (i) Ag, (ii) Au, (iii) Ca, Mg, Mn, W, Cr or Cu, (iv) Zn or Ge, and (v) Fe, Mo, Ni, Pd, Pt, Ti, V or Zr. Among these elements to be added to $A\ell$, (i) Ag, (ii) Au, (iii) Mg, Mn, W or Cr, (iv) Zn or Ge, and (v) Fe, Ni or Pd are preferable. In particular, (i) Ag, (iii) Mg, Mn, W or Cr, and (v) Ni or Pd are more preferable for improving heat-resistance or for facilitating the manufacturing process.

The proportion of these elements in the metal electrode is from 0.01 to 90 atom %, preferably from 0.1 to 25 atom %, and more preferably from 0.1 to 10 atom % in the case of elements of the above item (i), and is from 0.01 to 90 atom %, preferably from 0.1 to 20 atom %, and more preferably from 0.1 to 10 atom % in the case of the above items (ii) to (v). Heat-resistance, adhesive strength or reflectivity of the metal electrode can be particularly improved in the above preferable range.

In any case, the proportion of the additional component is preferable from 0.1 to 50 atom % in order to sufficiently maintain the adhesion of Al to Si.

In order to avoid the reduction of reflectivity and the increase of electric resistance of the metal electrode as far as possible and to improve heat-resistance, the proportion of the above additional component element (except Au, Ag and Cu) is preferably not more than 10 atom %. Among the additional component elements belonging to the above items (iii) and (iv), the proportion of Ca, Mg, Cu, Ge and the like, the melting point of which is lower than that of Si, is preferably within a solid solution scope with $A\ell$ at about 200°C, as the diffusion of Ca, Mg, Cu, Ge and the like into the semiconductor due to heating cannot be sufficiently prevented if the proportion thereof is beyond a solid solution component with $A\ell$.

The above explanation relates to a binary system. However, the same effect as in a binary system can be obtained by suitably combining elements belonging to items (i) to (v) in the case of a ternary system, quarternary system and the like. When not less than two kinds of elements are added to $A\ell$, such elements may either be selected from different groups or from the same group.

The thickness of the metal electrode is preferably from 2 to 10000 nm (20 to 100000 angstroms), more preferably from 4 to 500 nm (40 to 5000 angstroms). If the thickness is not less than 4 nm (40 angstroms), a superior uniformity of the film can be obtained. But, one cannot expect to increase the thickness of a film over 50 nm (500 angstroms), even if the film-forming time is extended an costs are higher.

The thickness of the metal electrode can be measured by using a quartz oscillator thickness monitor during the process of vacuum deposition, or can be measured by using a calibration curve based on the thickness obtained by means of a surface analysis such as SIMS.

The metal electrode is, in general, electrically connected to a p-type semiconductor layer, an n-type semiconductor layer, or to both p-type and n-type semiconductors.

It is preferable that the above -mentioned additional metals (i) to (v) exist in a uniform component in the electrode. However, it is possible to form a plurality of layers having different components in the electrode. For example, a first layer comprising $A\ell$-Ag can be formed on an amorphous silicon semiconductor layer, and thereon a layer composing solely of $A\ell$ or Ag can be formed as a second layer. In this case, the thickness of the first layer is preferably from 2 to 10 nm (about 100 angstroms).

When a second electrode is formed on a semiconductor in such a way that the semiconductor is sandwiched between the above metal electrode and the second electrode, representative examples of the second electrode are electrodes composed of a metal compound and the like comprising ITO ITO/SnO$_2$, In$_2$O$_3$, Cd$_x$SnO$_y$ (wherein x and y satisfy the relationships of $0.5 \leqq x \leqq 2$ and $2 \leqq y \leqq 4$, respectively), Ir$_z$O$_{1-z}$(wherein z satisfies the relationship of $0.33 \leqq z \leqq 0.5$), and the like. However, the employable second electrodes are not limited to those described above.

In the present specification, "semiconductor device" means a solar cell, photosensor, photosensitive drum, thin film transistor, electroluminescent device, and the like having 0.01 to 100 μm of amorphous semiconductor which might contain microcrystals.

The following is an explanation of a method for producing a semiconductor device of the present invention using, as an example, a solar cell wherein a p-type, i-type and n-type semiconductor are formed in this order from a side of light incidence.

First of all, on a transparent substrate whereon a transparent electrode is provided, layers of a p-type a-SiC:H, an i-type a-Si:H and an n-type μc-Si:H for example are formed by means of the plasma CVD method. Thereafter, a metal electrode having a predetermined thickness is formed on the n-type μc-Si:H layer by means of the electron beam vacuum deposition method. The source of vacuum deposition can be an Al alloy which provides a deposition having a predetermined component. The metal electrode can also be obtained by means of the multi-electron beam method wherein beams are alternately irradiated to Al and other component elements to provide a deposition having a predetermined component. The metal electrode can be formed by sputtering an Al alloy target which provides a deposition having a predetermined component, or by co-sputtering Al and other component elements. The metal electrode can of course be formed by means of the resistance heating vacuum deposition method using a vacuum deposition source comprising an Al alloy, or by means of the multi-vacuum deposition method. In forming a metal electrode, the temperature of the substrate whereon a p-type, i-type and n-type semiconductor layers are formed is from room temperature to 300°C, preferably from room temperature to 200°C.

Although the above explanation is based on the pin-type solar cell, the above production method and conditions are preferably applied to a pi-type or pn-type solar cell, a tandem-type solar cell wherein at least one kind of the above semiconductors (i.e. pin-type, pi-type, or pn type semiconductors) is used and other types of semiconductor devices. Further, although the above explanation is based on a heterojunction solar cell, the solar cell can of course be a homojunnction solar cell.

The semiconductor device of the present invention produced in the manner described above has superior initial properties, and the diffusion is prevented of an element constituting a metal electrode into a semiconductor layer the diffusion of which is inherent in a semiconductor device having an Al electrode. Therefore, the device of the present invention is preferably employable in a solar cell, photosensor and the like which are(1) produced at a temperature of not less than 130°C, particularly not less than 150°C after a metal electrode has been formed on the semiconductor, or (2) can be used at a metal electrode temperature of more than 80°C.

The Examples of semiconductor devices of the present invention are explained below.

## Example 1

On a glass substrate of 1.1 mm thick, fluorine doped $SnO_2$ of a thickness of 450 nm (4500 angstroms) is deposited to form a transparent electrode. On the transparent electrode, (i) a mixture gas consisting of $SiH_4$, $CH_4$ and $B_2H_6$, (2) a mixture gas consisting of $SiH_4$ and $H_2$, and (3) a mixture gas consisting of $SiH_4$, $PH_3$ and $H_2$ are glow discharge decomposed in this order to form a p-type amorphous semiconductor layer of a thickness of 15 nm (150 angstroms), an i-type amorphous semiconductor layer 700 nm (7000 angstroms) thick, and an n-type microcrystalline semiconductor layer of a thickness of 30 nm (300 angstroms) under the following conditions.

Substrate temperature: about 200°C
Pressure in a reaction
Chamber: 67 to 133 Pa (0.5 to 1 Torr)

Thereafter, a metal electrode of a thickness of 500 nm (5000 angstroms) comprising an alloy of Al and Ag (Al: 97 atom %, Ag: 3 atom %) is formed by means of the electron beam vacuum deposited method, maintaining the temperature of the substrate at 150°C.

The average properties of the fifty solar cells are evaluated when obtained and after they have been heated at 200°C for six hours. The results are summarized in Table 1.

The properties of the solar cells are measured under AM-1 illumination of 100 mW/cm² using a solar simulator.

## Example 2

Solar cells are produced in the same manner as in Example 1 except that an alloy of Al and Ag (Al: 75 atom %, Ag: 25 atom %) is used instead of an alloy of Al and Ag (Al: 97 atom %, Ag: 3 atom %) to form a metal electrode.

The average properties of the fifty solar cells are evaluated when obtained and after they have been heated at 200°C for six hours. The results are summarized in Table 1.

## Example 3

Solar cells are produced in the same manner as in Example 1 except that an alloy of Al and Mg (Al: 99 atom %, Mg: 1 atom %) is used instead of an alloy of Al and Ag (Al: 97 atom %, Ag: 3 atom %) to form a metal electrode.

The average properties of the fifty solar cells are evaluated when obtained and after they have been heated at 200°C for six hours. The results are summarized in Table 1.

Comparative Example 1

Solar cells are produced in the same manner as in Example 1 except that only Al is used instead of an alloy of Al and Ag (Al: 97 atom %, Ag: 3 atom %) to form a metal electrode.

The average properties of the fifty solar cells are evaluated when obtained and after they have been heated at 230°C for six hours. The results are summarized in Table 1.

Examples 4 to 6

Solar cells are produced in the same manner as in Example 1 except that an alloy of Al and Au (Al: 98 atom %, Au: 2 atom %) (Example 4), an alloy of Al and Zn (Al: 95 atom %, Zn: 5 atom %) (Example 5), and an alloy of Al and Ni (Al: 98 atom %, Ni: 2 atom %) (Example 6) are used instead of an alloy of Al and Ag (Al: 97 atom %, Agl: 3 atom %) to form metal electrodes.

A heat test is carried out on each of the two solar cells obtained. In each Example, the conversion efficiency after heating is still not less than 80 % of the conversion coefficient before heating. The results are summarized in Table 1.

EP 0 235 785 B1

Table 1

| | Solar cell property after the production | | | | solar cell property after heating for six hours | | | | Heating temperature ($^{O}$C) |
|---|---|---|---|---|---|---|---|---|---|
| | Jsc (mA/cm$^2$) | Voc (v) | FF (%) | η (%) | Jsc (mA/cm$^2$) | Voc (v) | FF (%) | η (%) | |
| Ex. 1 | 15.7 | 0.90 | 64.5 | 9.1 | 15.2 | 0.90 | 64.5 | 8.8 | 200 |
| Ex. 2 | 15.7 | 0.90 | 64.0 | 9.0 | 15.3 | 0.90 | 64.0 | 8.8 | 200 |
| Ex. 3 | 15.3 | 0.89 | 63.5 | 8.6 | 15.0 | 0.88 | 63.5 | 8.4 | 200 |
| Ex. 4 | 15.4 | 0.90 | 63.1 | 8.7 | 15.0 | 0.90 | 62.9 | 8.5 | 200 |
| Ex. 5 | 15.1 | 0.88 | 62.8 | 8.3 | 14.8 | 0.88 | 62.5 | 8.1 | 200 |
| Ex. 6 | 15.5 | 0.90 | 63.7 | 8.9 | 15.1 | 0.90 | 63.6 | 8.6 | 200 |
| Com.Ex.1 | 15.9 | 0.90 | 65.0 | 9.3 | 10.3 | 0.36 | 42,3 | 1.6 | 200 |

As explained earlier, in the semiconductor device of the present invention, one can prevent the diffusion of a metal constituting a metal electrode into a semiconductor layer when the semiconductor device is exposed to a relatively high temperature, for example, when the semiconductor device is produced or when it is used. This can be done by forming a metal electrode (which is electrically connected to an amorphous semiconductor which might contain microcrystal) consisting of $A\ell$ as a first component and an additional component added to the first component comprising at least one element selected from the group consisting of Ag, Au, Ca, Mg, Mn, W, Cr, Cu, Zn, Ge, Fe, Mo, Ni, Pd, Pt, Ti, V and Zr. Thereby, the degradation of the properties of the semiconductor device can be substantially prevented. Further, the yield of products can be improved and their lifetime greatly lengthened.

## Claims

1. A semiconductor device comprising an amorphous semiconductor which might contain microcrystals and a metal electrode electrically connected to the amorphous semiconductor and containing $A\ell$ as a first component, characterized in that at least one element selected from the group consisting of (i) Ag, (ii) Au, (iii) Ca, Mg, Mn, W, Cr or Cu, (iv) Zn or Ge, and (v) Fe, Mo, Ni, Pd, Pt, Ti, V or Zr is added to the first component as an additional component of the metal electrode, in order to prevent diffusion of $A\ell$ into said semiconductor.

2. The semiconductor device of Claim 1, wherein the additional component of the metal electrode is at least one element selected from the group consisting of (i) Ag, (ii) Au, and (iii) Ca, Mg, Mn, W, Cr or Cu.

3. The semiconductor device of Claim 1, wherein the additional component of the metal electrode is at least one element selected from the group consisting of (i) Ag, (iii) Mg, Mn or Cr, (iv) Zn or Ge, and (v) Fe, Ni or Pd.

4. The semiconductor device of any of Claims 1 to 3, wherein the content of the additional component of the metal electrode is from 0.01 to 90 atom %.

5. The semiconductor device of any of claims 1 to 4, wherein the content of the additional component of the metal electrode is from 0.10 to 25 atom % in the case of Ag, and is from 0.10 to 20 atom % in the case of elements other than Ag.

6. The semiconductor device of any one of Claims 1 to 5, wherein the thickness of the metal electrode is from 2 to 10000 nm.

7. The semiconductor device of any of Claims 1 to 6, wherein the thickness of the amorphous semiconductor which might contain microcrystals is from 0.01 to 100 µm.

8. The semiconductor device of any one of Claims 1 and 7, wherein the amorphous semiconductor which might contain microcrystalsis a semiconductor selected from the group consisting of a pin-type semiconductor, a pi-type semiconductor, a pn-type semiconductor and a laminated semiconductor composed of at least one kind of the pin-type, pi-type and pn-type semiconductors.

9. The semiconductor device of any one of Claims 1 to 8, wherein the metal electrode is electrically connected to a p-type semiconductor, an n-type semiconductor, or to both a p-type and an n-type semiconductor.

10. The semiconductor device of Claim 1, wherein (i) the proportion of Ag is 0.1 to 25 atom %, (iii) the proportion of Cr is 0.1 to 12 atom % and the proportion of Mg, Mn or W is 0.1 to 20 atom %, and (v) the proportion of Fe, Ni or Pd is 0.1 to 20 atom %, and the thickness of the metal electrode is 5 to 500 nm.

11. The semiconductor device of Claim 1, wherein (i) the proportion of Ag is 0.1 to 25 atom %, (iii) the proportion of Cr is 0.1 to 12 atom % and the proportion of Mg, Mn or W is 0.1 to 20 atom %, and (v) the proportion of Fe, Ni or Pd is 0.1 to 20 atom %, and the metal electrode has a double layer construction of an Al-alloy/metal wherein the thickness of the Al-alloy is 2 to 10 nm.

12. The semiconductor device of Claim 11, wherein the thickness of the metal is 50 to 500 nm.

13. The semiconductor device of Claim 11, wherein the metal is Al or Ag.

## Patentansprüche

1. Halbleitervorrichtung mit einem gegebenenfalls Mikrokristalle enthaltenden, amorphen Halbleiter und einer Metallelektrode, die elektrisch mit dem amorphen Halbleiter verbunden ist und Al als erste Komponente enthält, **dadurch gekennzeichnet**, daß mindestens ein Element aus der Gruppe, die (i) Ag, (ii) Au, (iii) Ca, Mg, Mn, W, Cr oder Cu, (iv) Zn oder Ge und (v) Fe, Mo, Ni, Pd, Pt, Ti, V oder Zr enthält, zur ersten Komponente als Zusatzkomponente der Metallelektrode zugegeben wird, um eine Diffusion des Al in den Halbleiter zu verhindern.

2. Halbleitervorrichtung nach Anspruch 1, wobei die Zusatzkomponente der Metallelektrode mindestens ein Element ist aus der Gruppe, die (i) Ag, (ii) Au und (iii) Ca, Mg, Mn, W, Cr oder Cu enthält.

3. Halbleitervorrichtung nach Anspruch 1, wobei die Zusatzkomponente der Metallelektrode mindestens ein Element ist aus der Gruppe, die (i) Ag, (iii) Mg, Mn oder Cr, (iv) Zn oder Ge und (v) Fe, Ni oder Pd enthält.

4. Halbleitervorrichtung nach einem der Ansprüche 1 bis 3, wobei der Anteil der Zusatzkomponente der Metallelektrode von 0,01 bis 90 Atom-% beträgt.

5. Halbleitervorrichtung nach einem der Ansprüche 1 bis 4, wobei der Anteil der Zusatzkomponente der Metallelektrode von 0,10 bis 25 Atom-% im Falle von Ag und von 0,10 bis 20 Atom-% im Falle der Elemente mit Ausnahme von Ag beträgt.

6. Halbleitervorrichtung nach einem der Ansprüche 1 bis 5, wobei die Dicke der Metallelektrode von 2 bis 10 000 nm beträgt.

7. Halbleitervorrichtung nach einem der Ansprüche 1 bis 6, wobei die Dicke des gegebenenfalls Mikrokristalle enthaltenden, amorphen Halbleiters von 0,01 bis 100 μm beträgt.

8. Halbleitervorrichtung nach einem der Ansprüche 1 bis 7, wobei der gegebenenfalls Mikrokristalle enthaltende, amorphe Halbleiter ein Halbleiter ist, der aus der Gruppe ausgewählt ist, die einen pin-Halbleiter, einen pi-Halbleiter, einen pn-Halbleiter und einen laminierten Halbleiter, der aus mindestens einer Art der pin-, pi-und pn-Halbleiter besteht, aufweist.

9. Halbleitervorrichtung nach einem der Ansprüche 1 bis 8, wobei die Metallelektrode elektrisch mit einem p-Halbleiter und/oder einem n-Halbleiter verbunden ist.

10. Halbleitervorrichtung nach Anspruch 1, wobei (i) der Anteil von Ag von 0,1 bis 25 Atom-%, (iii) der Anteil von Cr von 0,1 bis 12 Atom-% und der Anteil von Mg, Mn oder W von 0,1 bis 20 Atom-% und (v) der Anteil von Fe, Ni oder Pd von 0,1 bis 20 Atom-% und die Dicke der Metallelektrode von 5 bis 500 nm betragen.

11. Halbleitervorrichtung nach Anspruch 1, wobei (i) der Anteil von Ag von 0,1 bis 25 Atom-%, (iii) der Anteil von Cr von 0,1 bis 12 Atom-% und der Anteil von Mg, Mn oder W von 0,1 bis 20 Atom-% und (v) der Anteil von Fe, Ni oder Pd von 0,1 bis 20 Atom-% betragen und die Metallelektrode einen Doppelschichtaufbau aus einer Al-Legierung/Metall hat, wobei die Dicke der Al-Legierung von 2 bis 10 nm beträgt.

12. Halbleitervorrichtung nach Anspruch 11, wobei die Dicke des Metalls von 50 bis 500 nm beträgt.

13. Halbleitervorrichtung nach Anspruch 11, wobei als Metall Al oder Ag verwendet wird.

## Revendications

1. Dispositif semi-conducteur comprenant un semi-conducteur amorphe qui peut contenir des microcristaux et une électrode métallique reliée électriquement au semi-conducteur amorphe et contenant Al en tant que premier composant, caractérisé en ce qu'au moins un élément choisi parmi le groupe constitué par (i) Ag, (ii) Au, (iii) Ca, Mg, Mn, W, Cr ou Cu, (iv) Zn ou Ge et (v) Fe, Mo, Ni, Pd, Pt, Ti, V ou Zr est ajouté au premier composant en tant que composant d'addition de l'électrode métallique pour empêcher la diffusion de Al dans le semi-conducteur.

2. Dispositif semi-conducteur selon la revendication 1, dans lequel le composant d'addition de l'électrode métallique est au moins un élément choisi parmi le groupe constitué par (i) Ag, (ii) Au, et (iii) Ca, Mg, Mn, W, Cr ou Cu.

3. Dispositif semi-conducteur selon la revendication 1, dans lequel le composant d'addition de l'électrode métallique est au moins un élément choisi parmi le groupe constitué par (i) Ag, (iii) Mg, Mn ou Cr, (iv) Zn ou Ge, et (v) Fe, Ni ou Pd.

4. Dispositif semi-conducteur selon l'une quelconque des revendications 1 à 3, dans lequel la teneur du composant d'addition de l'électrode métallique va de 0,01 jusqu'à 90 atomes %.

5. Dispositif semi-conducteur selon l'une quelconque des revendications 1 à 4, dans lequel la teneur en composant d'addition de l'électrode métallique va de 0,10 jusqu'à 25 atomes % dans le cas de Ag, et va de 0,10 à 20 atomes % dans le cas des éléments autres que Ag.

6. Dispositif semi-conducteur selon l'une quelconque des revendications 1 à 5, dans lequel l'épaisseur de l'électrode métallique va de 2 jusqu'à 10 000 nm.

7. Dispositif semi-conducteur selon l'une quelconque des revendications 1 à 6, dans lequel l'épaisseur du semi-conducteur amorphe pouvant contenir des microcristaux va de 0,01 jusqu'à 100 μm.

8. Dispositif semi-conducteur selon l'une quelconque des revendications 1 à 7, dans lequel le semiconducteur amorphe qui peut contenir des micro-cristaux est un semi-conducteur choisi parmi le groupe constitué par un semi-conducteur du type à broche, un semiconducteur du type pi, un semi-conducteur de type pn et un semi-conducteur stratifié constitué par au moins une catégorie de semi-conducteur du type broche, du type pi et du type pn.

9. Dispositif semi-conducteur selon l'une quelconque des revendications 1 à 8, dans lequel l'électrode métallique est reliée électriquement à un semiconducteur de type p, à un semi-conducteur de type n, ou à la fois à un semi-conducteur de type p et à un semiconducteur de type n.

10. Dispositif semi-conducteur selon la revendication 1, dans lequel (i) la proportion d'Ag est de 0,1 jusqu'à 25 atomes %, (iii) la proportion de Cr est de 0,1 jusqu'à 12 atomes % et la proportion de Mg, Mn ou W est de 0,1 jusqu'à 20 atomes %, et (v) la proportion de Fe, Ni ou Pd est de 0,1 jusqu'à 20 atomes % et l'épaisseur de l'électrode métallique est de 5 jusqu'à 500 nm.

11. Dispositif semi-conducteur selon la revendication 1, dans lequel (i) la proportion d'Ag est de 0,1 jusqu'à 25 atomes %, (iii) la proportion de Cr est de 0,1 jusqu'à 12 atomes % et la proportion de Mg, Mn ou W est de 0,1 jusqu'à 20 atomes %, et (v) la proportion de Fe, Ni ou Pd est de 0,1 jusqu'à 20 atomes %, et l'électrode métallique comporte une construction à double couche d'un alliage Al/métal dans lequel l'épaisseur de l'alliage Al est de 2 jusqu'à 10 nm.

12. Dispositif semi-conducteur selon la revendication 11, dans lequel l'épaisseur du métal est de 50 à 500 nm.

13. Dispositif semi-conducteur selon la revendication 11, dans lequel le métal est Al ou Ag.